# FASCICULE DE BREVET EUROPEEN

(11) **EP 0 677 907 B1**
(45) Date de publication et mention de la délivrance du brevet: **14.07.1999**
(21) Numéro de dépôt: 95410029.3
(22) Date de dépôt: 11.04.1995
(51) Int. Cl.: H02H 3/06, H03K 17/08, H02H 9/02

(54) **Dispositif de protection contre les surintensités**
Überstromschutzvorrichtung
Overcurrent protection device

(30) Priorité: 13.04.1994 FR 9404680
(43) Date de publication de la demande: 18.10.1995
(73) Titulaire: STMicroelectronics S.A., 94250 Gentilly (FR)
(72) Inventeur: Rault, Pierre, F-37540 Saint Cyr Sur Loire (FR)
(74) Mandataire: de Beaumont, Michel

(56) Documents cités:
- EP-A- 0 404 692
- US-A- 3 792 289
- US-A- 3 916 220

## Description

La présente invention concerne un disjoncteur statique destiné à protéger une charge alimentée sous une tension de quelques centaines de volts.

Pour remplir la fonction de disjoncteur statique, les dispositifs disponibles actuellement sont le fusible, la résistance à coefficient de température positif, le disjoncteur électromagnétique.

Les inconvénients de ces dispositifs résident, pour le fusible, dans le fait qu'il ne remplit sa fonction qu'une seule fois et qu'il doit être ensuite remplacé, pour la résistance à coefficient de température, dans son temps de réponse et sa limitation à une utilisation pour des charges de faible puissance, et pour le disjoncteur électromagnétique, dans son temps de réponse et son coût de fabrication.

On connaît également des circuits électroniques remplissant la fonction de disjoncteurs statiques qui ont recours à des interrupteurs à transistors. De tels circuits doivent présenter un temps de réponse extrêmement faible en cas de court-circuit dans la charge en raison du courant important qui circule pendant un court-circuit. Cela conduit à réaliser des circuits électroniques complexes pour éviter qu'ils soient endommagés par ce courant de court-circuit. Il s'ensuit un coût important pour ce type de circuits.

L'invention concerne plus particulièrement un dispositif de protection d'une charge contre les surintensités constitué par un circuit électronique.

Elle a pour objet de réaliser un dispositif de protection contre les surintensités sous la forme d'un circuit électronique qui soit de constitution simple et de faible coût, tout en assurant une fiabilité de fonctionnement optimale dans sa fonction de protéger la charge.

US- A- 3 792 289 divulgue un dispositif de protection conforme au préambule de la revendication 1. Dans ce dispositif connu, l'élément limiteur de courant est constitué par une résistance. Cette résistance dissipe de l'énergie en fonctionnement normal, c'est- à- dire en l'absence de surintensité ou court- circuit. L'invention a pour but de procurer un dispositif de protection présentant une faible dissipation d'énergie en fonctionnement normal.

Pour atteindre ce but, la présente invention prévoit un dispositif de protection contre les surintensités destiné à être intercalé en série entre une et une alimentation électrique, comportant un commutateur électronique commandé par la tension présente aux bornes d'un élément limiteur de courant monté en série avec ledit commutateur électronique, caractérisé en ce que ledit élément limiteur est d'un type qui limite le courant à une valeur déterminée, constante sur une large plage de tension

Selon un mode de réalisation de la présente invention, ledit commutateur est constitué par un thyristor GTO ouvrable par la gâchette, monté en série avec l'élément limiteur de courant, la cathode dudit thyristor GTO étant reliée à l'entrée du limiteur de courant et l'anode du thyristor GTO recevant la tension d'alimentation alors que la sortie de l'élément limiteur de courant est reliée à la charge, une première résistance de forte valeur étant disposée entre la gâchette et l'anode du thyristor GTO.

Selon un mode de réalisation de la présente invention, le dispositif comporte une diode à avalanche, montée en parallèle avec l'élément limiteur de courant et destinée à fixer le seuil d'ouverture dudit commutateur constitué par le thyristor GTO.

Selon un mode de réalisation de la présente invention, le dispositif comporte un thyristor auxiliaire destiné à commander l'ouverture du thyristor GTO dès que la tension aux bornes de l'élément limiteur de courant atteint le seuil fixé par la tension d'avalanche de la diode, la gâchette du thyristor auxiliaire étant reliée à l'anode de la diode à avalanche et sa cathode étant reliée à la sortie du limiteur de courant, tandis que son anode est reliée à la gâchette du thyristor GTO.

Selon un mode de réalisation de la présente invention, le dispositif comporte en outre une seconde résistance, placée entre la gâchette et la cathode du thyristor auxiliaire, et destinée à absorber, en fonctionnement normal, le courant de fuite circulant dans la diode.

Selon un mode de réalisation de la présente invention, l'élément limiteur de courant et le thyristor ouvrable par la gâchette sont choisis de sorte que la valeur du courant de limitation "Icl" du limiteur de courant soit inférieure à la valeur du courant maximum d'ouverture du thyristor GTO.

Le fait, selon l'invention, d'avoir recours à un élément limiteur de courant permet de simplifier considérablement la constitution du circuit. En effet, il ne risque plus d'être endommagé, par un courant important circulant dans la charge, au début de la phase de court-circuit, pendant le temps de réponse du commutateur qui n'a donc pas besoin d'être commandé très rapidement. De plus, comme les composants utilisés ne risquent pas d'être soumis à un régime de surcharge, ils peuvent être de petite dimension et donc occuper une faible surface de silicium.

Ces objets, caractéristiques et avantages ainsi que d'autres de la présente invention seront exposés en détail dans la description suivante d'un mode de réalisation particulier faite à titre non limitatif en relation avec les figures jointes parmi lesquelles :
la figure 1 représente la caractéristique tension-courant d'un élément limiteur de courant ;
la figure 2 représente le schéma d'un mode de réalisation de dispositif de protection contre les surintensités selon l'invention ; et
la figure 3 représente la caractéristique tension-courant du dispositif selon la figure 2.

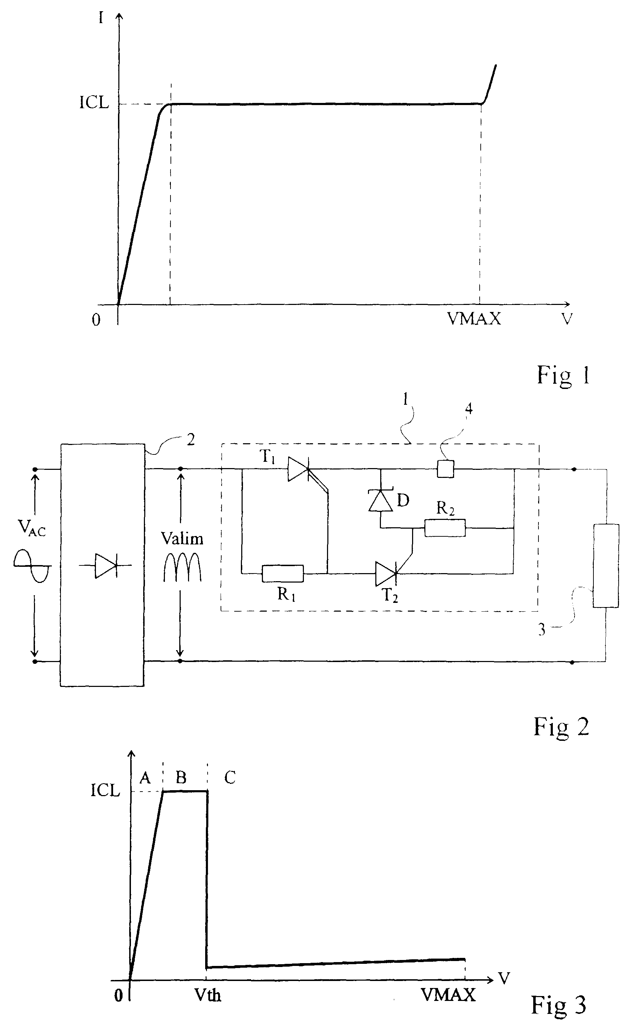

Comme le montre la figure 1, un élément limiteur de courant, du type utilisé selon l'invention, présente une caractéristique tension-courant correspondant à celle d'un transistor MOS à gâchette et source reliées. Lorsque le courant dans cet élément augmente, il se comporte comme une résistance de faible valeur. Quand le courant atteint une valeur limite "Icl", le courant est limité à cette valeur et la tension aux bornes du limiteur augmente. La limite de fonctionnement du dispositif est fixée par une tension "Vmax" au-delà de laquelle l'élément entre en avalanche.

Le dispositif de protection 1, selon l'invention, tel que représenté à la figure 2 reçoit un signal d'alimentation, sinusoïdal redressé et non filtré "Valim", issu d'un pont de diode 2 alimenté, par exemple, par la tension alternative "Vac" du réseau industriel à 220 V. Le dispositif 1 délivre ce signal redressé à une charge 3. Il est destiné à fonctionner en disjoncteur, c'est-à-dire à se comporter comme un circuit ouvert en cas de surintensité due à une surtension sur le réseau, ou de mise en court-circuit temporaire ou permanente de la charge.

Le dispositif 1 comporte un thyristor ouvrable par la gâchette T1 (couramment appelé thyristor GTO) en série avec un élément limiteur de courant 4 et la charge à protéger 3. L'anode du thyristor T1 est connectée à la borne positive du pont 2. La deuxième borne de la charge 3 est connectée à la borne négative du pont 2. Le thyristor T1 joue le rôle d'un commutateur commandé par la tension présente aux bornes du limiteur 4. Sa gâchette est pour cela reliée à l'anode d'un thyristor auxiliaire T2 dont la cathode est reliée à la sortie du limiteur 4. La gâchette du thyristor auxiliaire T2 est reliée à l'anode d'une diode à avalanche D ainsi que, par l'intermédiaire d'une résistance R2, à sa propre cathode. La cathode de la diode à avalanche D est reliée à l'entrée du limiteur 4 de sorte que la diode mesure en quelque sorte la tension aux bornes du limiteur 4. Une résistance R1 de forte valeur est placée entre l'anode et la gâchette du thyristor GTO T1.

A la mise sous tension du dispositif 1, un courant circule dans la résistance R1, la jonction gâchette-cathode du thyristor T1, le limiteur 4 et la charge 3. Dès que ce courant est suffisant, le thyristor T1 s'amorce. Le thyristor T1 étant amorcé, un courant de charge normal circule à travers le limiteur de courant 4, et la charge 3 est alimentée.

En fonctionnement normal, c'est-à-dire en l'absence de surintensité ou court-circuit, le point de fonctionnement du limiteur 4 est dans sa zone de faible résistance (figure 1). Le dispositif 1 présente donc une faible dissipation d'énergie en fonctionnement normal.

En cas de surtension sur l'alimentation ou de court-circuit dans la charge 3, l'intensité traversant le limiteur 4 atteint la valeur seuil "Icl". Son point de fonctionnement passe donc dans la zone de limitation de courant ce qui a pour conséquence de faire croître la tension à ses bornes.

Lorsque cette tension atteint le seuil défini par la tension d'avalanche de la diode D, un courant circule à travers cette diode dans la gâchette du thyristor auxiliaire T2 qui s'amorce.

Cet amorçage de T2 a pour effet d'amener la différence de potentiel entre la gâchette et la cathode du thyristor GTO T1 à une valeur fortement négative et le thyristor GTO T1 se bloque. On notera que ce montage ne nécessite pas le choix d'un thyristor GTO de hautes performances puisque, pendant cette phase d'ouverture, le limiteur de courant 4 empêche le courant dans le thyristor GTO T1 d'atteindre une valeur élevée. Les deux conditions pour le blocage du thyristor GTO T1 sont remplies. Le dispositif 1 présente alors une impédance élevée, déterminée par la valeur de la résistance R1, qui s'oppose au passage du courant.

Pendant la phase de commutation, c'est-à-dire, d'ouverture du circuit, le courant de charge reste contrôlé et égal au courant de seuil "Icl" du limiteur de courant 4.

En cas d'alimentation "Valim" redressée non filtrée, c'est-à-dire présentant un passage à zéro à chaque alternance, le thyristor T2 se bloque au passage à zéro du signal, ce qui a pour effet de permettre au thyristor T1 de se réamorcer au début de l'alternance suivante. Le dispositif 1 va ainsi successivement se déclencher et se réamorcer à chaque alternance tant que le court-circuit persiste dans la charge 3. Dès que le court-circuit aura disparu le fonctionnement normal pourra être repris sans qu'aucune intervention ait été nécessaire sur le dispositif de protection 1 qui constitue donc un disjoncteur à réarmement automatique sans précaution particulière.

Par contre, en cas d'alimentation continue ou redressée et filtrée (non représentée), pour que le thyristor T2 se réamorce quand le court-circuit dans la charge a disparu, il faudra sélectionner la valeur de la résistance R1 pour que, en présence d'une tension de réseau nominale et d'une valeur normale de la charge 3, elle impose un courant dans le thyristor T2 inférieur à son courant de maintien. On aura alors aussi obtenu un disjoncteur à réarmement automatique.

Le rôle de la résistance R2 de faible valeur est d'éviter un amorçage intempestif du thyristor T2 qui serait dû, même en l'absence de court-circuit, à un courant de fuite dans la diode à avalanche D qui pourrait déclencher le thyristor T2.

Comme on vient de le voir, le courant de charge est en permanence contrôlé par le dispositif 1, ce qui lui confère une fiabilité optimale.

La caractéristique tension-courant du dispositif selon l'invention telle que représentée à la figure 3 illustre le fonctionnement qui vient d'être décrit. En fonctionnement normal mais établi (zone A), c'est-à-dire après l'amorçage du thyristor GTO T1, la caractéristique du dispositif 1 suit celle du limiteur de courant (figure 1) dans sa zone de faible résistance. Lorsque l'intensité traversant le dispositif atteint la valeur "Icl", elle est limitée (zone B) et la caractéristique suit encore celle du limiteur de courant jusqu'à ce que la tension aux bornes du dispositif atteigne une valeur seuil "Vth" correspondant à la tension de seuil de la diode à avalanche D majorée de la tension de jonction gâchette-cathode du thyristor T2. A cet instant, sous l'effet de la commutation des thyristors, l'intensité chute brusquement pour atteindre une valeur correspondant à la limitation par la résistance R1 et atteindre une zone d'ouverture C.

Bien que le temps de commutation du circuit soit court, son temps de réponse qui est fixé par la tension d'avalanche de la diode D peut paraître important. Mais cela est sans conséquence sur la fiabilité du circuit et la protection de la charge dans la mesure où le courant est en permanence limité à la valeur "Icl" par le limiteur de courant 4.

A titre d'exemple non limitatif, on a réalisé un disjoncteur statique selon l'invention, fonctionnant sous une tension alternative de 220 V redressée par un pont de diode, pour alimenter une charge 3 constituée par une lampe de 100 W, en utilisant les composants suivants
- un élément limiteur de courant 4 ayant une valeur de courant de limitation "Icl" de 600 mA ;
- un thyristor ouvrable par la gâchette T1 connu sous la dénomination commerciale TN25-1600D (SOT82) ouvrable quand le courant qui le traverse ne dépasse pas 700 mA ;
- un thyristor T2 connu sous la dénomination commerciale PO102A (TO92) ;
- une diode à avalanche D dont la tension d'avalanche est de 12 V ;
- une résistance R1 de 27 kΩ ; et
- une résistance R2 de 100 Ω.

Bien entendu la présente invention est susceptible de diverses variantes et modifications qui apparaîtront à l'homme de l'art, chacun des composants décrits pouvant être remplacé par un ou plusieurs éléments remplissant la même fonction.

## Revendications

1. Dispositif (1) de protection contre les surintensités destiné à être intercalé en série entre une charge (3) et une alimentation électrique (2), comportant un commutateur électronique (T1) commandé par la tension présente aux bornes d'un élément limiteur de courant (4) monté en série avec ledit commutateur électronique (T1), caractérisé en ce que ledit élément limiteur (4) est d'un type qui limite le courant à une valeur déterminée, constante sur une large plage de tension.

2. Dispositif selon la revendication 1, caractérisé en ce que ledit commutateur est constitué par un thyristor GTO ouvrable par la gâchette (T1), monté en série avec l'élément limiteur de courant (4), la cathode dudit thyristor GTO (T1) étant reliée à l'entrée du limiteur de courant (4) et l'anode du thyristor GTO (T1) recevant la tension d'alimentation alors que la sortie de l'élément limiteur de courant (4) est reliée à la charge (3), une première résistance (R1) de forte valeur étant disposée entre la gâchette et l'anode du thyristor GTO (T1).

3. Dispositif selon la revendication 2, caractérisé en ce qu'il comporte une diode à avalanche (D), montée en parallèle avec l'élément limiteur de courant (4) et destinée à fixer le seuil d'ouverture dudit commutateur constitué par le thyristor GTO (T1).

4. Dispositif selon la revendication 3, caractérisé en ce qu'il comporte un thyristor auxiliaire (T2) destiné à commander l'ouverture du thyristor GTO (T1) dès que la tension aux bornes de l'élément limiteur de courant (4) atteint le seuil fixé par la tension d'avalanche de la diode (D), la gâchette du thyristor auxiliaire (T2) étant reliée à l'anode de la diode à avalanche (D) et sa cathode étant reliée à la sortie du limiteur de courant (4), tandis que son anode est reliée à la gâchette du thyristor GTO (T1).

5. Dispositif selon la revendication 4, caractérisé en ce qu'il comporte en outre une seconde résistance (R2), placée entre la gâchette et la cathode du thyristor auxiliaire (T2), et destinée à absorber, en fonctionnement normal, le courant de fuite circulant dans la diode (D).

6. Dispositif selon l'une quelconque des revendications 2 à 5, caractérisé en ce que l'élément limiteur de courant (4) et le thyristor ouvrable par la gâchette (T1) sont choisis de sorte que la valeur du courant de limitation "Icl" du limiteur de courant (4) soit inférieure à la valeur du courant maximum d'ouverture du thyristor GTO (T1).

## Claims

1. An overcurrent protection device (1) designed to be connected in series between a load (3) and an electric supply (2), including an electronic switch (T1) which is controlled by the voltage present across a current limiting device (4), serially connected with said electronic switch (T1), characterized in that said limiting device (4) is of a type that limits the current at a predetermined value that is constant on a broad voltage range.

2. The device of claim 1, characterized in that said switch is formed by a gate turnoff (GTO) thyristor (T1), in series with said current limiting device (4), the cathode of said GTO thyristor being connected to the input of the current limiting device and the anode of the GTO thyristor receiving the supply voltage whereas the output of the current limiting device is connected to the load (3), a first high-value resistor (R1) being disposed between the gate and the anode of the GTO thyristor (T1).

3. The device of claim 2, characterized in that it includes an avalanche diode (D), connected in parallel to the current limiting device (4) and intended to set the switching off threshold of said switch formed by the GTO thyristor (T1).

4. The device of claim 3, including an auxiliary thyristor (T2) designed to control the switching off of the GTO thyristor (T1) as soon as the voltage across the current limiting device (4) reaches the threshold fixed by the avalanche voltage of the diode (D), the gate of the auxiliary thyristor (T2) being connected to the anode of the avalanche diode (D) and its cathode being connected to the output of the current limiting device (4), whereas its anode is connected to the gate of the GTO thyristor (T1).

5. The device of claim 4, characterized in that it includes a second resistor (R2), disposed between the gate and the cathode of the auxiliary thyristor (T2), and designed to absorb, in normal operation, the leakage current flowing through the diode (D).

6. The device of any of claims 2 to 5, characterized in that the current limiting device (4) and the GTO thyristor (T1) are selected so that the limitation current value "Icl" of the current limiting device is lower than the value of the maximum turn off current of the GTO thyristor (T1).

## Patentansprüche

1. Überstromschutz-Vorrichtung zur Reihenschaltung zwischen einer Verbraucherlast (3) und einer elektrischen Speisestromquelle (2), mit einem elektronischen Schalter, der von einer an den Anschlüssen eines Strombegrenzerelements (4) anliegenden Spannung gesteuert wird, das in Reihe mit dem genannten elektronischen Schalter geschaltet ist,
**dadurch gekennzeichnet** daß das genannte Begrenzerelement (4) von solchem Typ ist, der den Strom auf einen vorgegebenen, über einen großen Spannungsbereich hin konstanten Wert begrenzt.

2. Vorrichtung nach Anspruch 1, dadurch gekennzeichnet, daß der genannte Schalter von einem durch das Gate ausschaltbaren, in Reihe mit dem Strombegrenzerelement (4) geschalteten GTO-Thyristor (T1) gebildet wird, wobei die Kathode des genannten GTO-Thyristors (T1) mit dem Eingang des Strombegrenzers (4) verbunden ist und die Anode des GTO-Thyristors (T1) die Speisespannung zugeführt erhält, während der Ausgang des Strombegrenzerelements (4) mit der Verbraucherlast (3) verbunden ist und zwischen dem Gate und der Anode des GTO-Thyristors (T1) ein erster Widerstand (R1) hohen Betrags angeordnet ist.

3. Vorrichtung nach Anspruch 2, dadurch gekennzeichnet, daß sie eine Lawinendiode (Z-Diode) (D) in Parallelschaltung zu dem Strombegrenzerelement (4) aufweist, die zur Einstellung des Öffnungs- bzw. Ausschaltschwellwerts des von dem GTO-Thyristor (T1) gebildeten Schalters bestimmt ist.

4. Vorrichtung nach Anspruch 3, dadurch gekennzeichnet, daß sie einen Hilfstransistor (T2), der zum Öffnen bzw. Ausschalten des GTO-Thyristors bestimmt ist, sobald die Spannung an den Anschlüssen des Strombegrenzerelements (4) den durch die Lawinendurchbruchspannung der Diode (D) eingestellten Schwellwert erreicht, wobei das Gate des Hilfsthyristors (T2) mit der Anode der Lawinen- bzw. Z-Diode (D) verbunden ist und seine Kathode mit dem Ausgang des Strombegrenzers (4) verbunden ist, während seine Anode mit dem Gate des GTO-Thyristors (T1) verbunden ist.

5. Vorrichtung nach Anspruch 4, dadurch gekennzeichnet, daß sie des weiteren einen zweiten Widerstand (R2) aufweist, der zwischen dem Gate und der Kathode des Hilfsthyristors (T2) angeordnet ist und dazu bestimmt ist, im Normalbetrieb den in der Diode (D) fließenden Leckstrom aufzunehmen.

6. Vorrichtung nach einem der Ansprüche 2 bis 5, dadurch gekennzeichnet, daß das Strombegrenzerelement (4) und der durch das Gate ausschaltbare Thyristor (T1) so gewählt sind, daß der Betrag des Begrenzungsstroms "Icl" des Strombegrenzerelements (4) kleiner als der Betrag des maximalen Öffnungs- bzw. Abschaltstroms des GTO-Thyristors (T1) ist.
